# EUROPEAN PATENT SPECIFICATION

(11) **EP 2 900 737 B1**
(45) Date of publication and mention of the grant of the patent: **20.07.2016**
(21) Application number: 13770895.4
(22) Date of filing: 27.09.2013
(51) Int. Cl.: C08J 5/04, C08J 5/22, C08K 3/04, H01B 1/22, H01B 1/24, H01L 41/09, C09D 5/24, C08J 9/00, C09D 183/04, H01L 41/45, H01L 41/193, C08L 21/00

(54) **MECHANICALLY INVISIBLE POLYMER COATINGS**
MECHANISCH UNSICHTBARE POLYMERBESCHICHTUNGEN
REVÊTEMENTS POLYMÈRES INVISIBLES MÉCANIQUEMENT

(30) Priority: 28.09.2012 EP 12186519
(43) Date of publication of application: 05.08.2015
(73) Proprietor: Danmarks Tekniske Universitet, 2800 Kgs. Lyngby (DK)
(72) Inventor: SKOV, Anne Ladegaard, DK-2000 Frederiksberg (DK)
(74) Representative: Inspicos P/S
(86) International application number: PCT/EP2013/070153
(87) International publication number: WO 2014/049102

(56) References cited:
- EP-A1- 2 239 793
- WO-A1-03/028039
- WO-A1-2011/136440
- GB-A- 1 408 000
- US-A1- 2012 060 355

## Description

### FIELD OF THE INVENTION

The present invention relates to a composition comprising encapsulated particles in a polymeric material. The invention relates in particular to a composition comprising encapsulated particles in elastomers for use in electroactive polymers (EAPs) in order to obtain mechanically invisible polymer coatings.

### BACKGROUND OF THE INVENTION

Electroactive polymers (EAPs) are polymers that exhibit a change in size or shape when stimulated by an electric field or reversibly generate energy when motioned. Typically, an EAP is able to undergo a major deformation while sustaining large forces.

The development of elastomeric materials with high dielectric permittivity has attracted increased interest over the last years due to their use in e.g. dielectric electroactive polymers (DEAP's).

Dielectric electroactive polymers are materials in which actuation is caused by electrostatic forces on a film of DEAP's sandwiched between two electrodes which squeeze the polymers upon application of an electric field. When an electric voltage is applied, an electrostatic pressure is exerted on the film, reducing its thickness and expanding its area due to the applied electric field. Examples of DEAP's are dielectric elastomers. Dielectric electroactive polymers are used e.g. as so-called "artificial muscles" and in energy-harvesting.

In order to improve the mechanical properties of electroactive polymers, such as dielectric electroactive polymers, a well-known technique to improve the tear strength thereof is to add fillers. However, addition of filler particles often leads to inhomogeneous dispersion and consequent agglomeration. In order to obtain better dispersion of filler particles encapsulation of particles in polymeric materials is a well-known method for dispersion, wherein percolation (agglomeration or rather path-through through the material) of the filler particles would cause breakdown or wherein extra protection of filler particles is desired. This may be the case in e.g. electroactive polymers comprising particles of conductive material wherein as high permittivity as possible is desired, but wherein conductivity due to percolation of the conductive particles means that the system is short-circuited and consequently permanently damaged.

Dispersion of particles through mechanical mixing in order to enhance permittivity does not allow sufficiently homogenous dispersion of the particles in question.

Opris et al., "New Silicone Composites for Dielectric Elastomer Actuator Applications in Competition with Acrylic Foil", Advanced Functional Materials, 2011, XXI, 3531, discloses several polydimethylsiloxane elastomers containing conductive polyaniline particles.

Kussmaul et al., "Matrix stiffness dependent electro-mechanical response of dipole grafted silicones", Smart Materials and Structures, 2012, 21, 064005, discloses modification of the dielectric and mechanical properties of dielectric elastomer actuators in a silicone elastomer network comprising cross-linker, chains and grafted molecular dipoles.

US 4,777,205 discloses electrically conductive organopolysiloxane compositions containing silver coated mica particles, wherein a conductive material is placed on a carrier.

US 2012/0128960 A1 discloses an electro-switchable polymer film assembly having a first and a second surface side, comprising at least one pair of electrodes and a polymer matrix, wherein structuring particles can be embedded in the polymer matrix and the polymer matrix or the structuring particles consist of an electro-active polymer.

For use as electroactive polymers, such as dielectric electroactive polymers, both the electrically insulating properties as well as the mechanical properties of the polymer have to be tightly controlled in order not to destroy the mechanical properties by the addition of particles.

The prior art methods of encapsulating particles typically result in the polymer losing mechanical strength due to the large total surface area of the particles and thus weak strength of the polymer. Consequently the polymer will break at low stress or may even liquefy.

### OBJECT OF THE INVENTION

It is an object of embodiments of the invention to provide a composition of a polymeric material having high dielectric permittivity without compromising the mechanical strength thereof.

### SUMMARY OF THE INVENTION

It has been found by the present inventor(s) that by encapsulating a filler material in a polymeric material substantially similar to the polymeric material of the surrounding continuous phase, thereby making the encapsulation chemically substantially similar to the surrounding continuous phase, the mechanical properties of the resulting composition is improved since the encapsulation becomes mechanically "invisible".

So, in a first aspect the present invention relates to a composition comprising a continuous phase and a discontinuous phase incorporated therein, wherein the continuous phase comprises a first polymeric material and wherein the discontinuous phase comprises particles, said particles comprising a filler material and an encapsulating coating of a second polymeric material, wherein the backbones of the first and second polymeric materials are the same.

In a second aspect the present invention relates to a method for the preparation of a composition according to the invention, comprising the steps:
i) preparing particles comprising a filler material;
ii) Encapsulating said particles, optionally with heating, with a second polymeric material to obtain encapsulated particles;
iii) Mixing the encapsulated particles obtained in ii), optionally with heating, with a first polymeric material to obtain a composition comprising a continuous phase and a discontinuous phase.

In a third aspect the present invention relates to a use of the composition according to the invention as electroactive polymer.

In a fourth aspect the present invention relates to a use of the composition according to the invention for the preparation of closed cell foams.

### DETAILED DISCLOSURE OF THE INVENTION

### Definitions

In the present context the term "elastomer" refers to compositions of matter that have a glass transition temperature, Tg, at which there is an increase in the thermal expansion coefficient, and includes both amorphous polymer elastomers and thermoplastic elastomers (thermoplastics). An elastomer exhibits an elasticity deriving from the ability of the polymer chains of the elastomer to reconfigure themselves to distribute an applied stress.

In the present context the term "first polymeric material" and "second polymeric material", respectively, refers to a polymeric material, which in each instance may consist of a single polymer or a blend of more than one polymeric entity having the same or different substituent groups but having the same backbone.

In the present context the term "backbone" of the first and second polymeric material, respectively, means the continuous chain of the polymer molecule in question.

In the present context the term "the backbones of the first and second polymeric materials are the same" means that the continuous chain of the polymer molecules in question are of the same chemical composition but may vary in length".

In the present context the term "at least 80% by mole of the substituent groups...are identical" means that at least 80 % by mole of the substituent groups on the backbones of said first and second polymeric materials, taken as a whole, are the same in the first and second polymeric material. Thus the order of the individual substituents may vary as long as the overall composition fulfils the above criterium.

The term "curing" in the present context refers to the process of cross-linking of polymer chains.

### Specific embodiments of the invention

In an embodiment of the invention at least 80 % by mole of the substituent groups on the backbones of said first and second polymeric materials are identical.

In another embodiment of the invention at least 85 % by mole of the substituent groups on the backbones of said first and second polymeric materials are identical, preferably at least 90 % by mole, more preferably at least 95 % by mole of the substituent groups on the backbones of said first and second polymeric materials.

Thus by encapsulating the particles in a polymer similar in composition to the polymer of the continuous phase the encapsulation will have substantially the same properties as the continuous phase and thus becomes mechanically "invisible". In this way the encapsulated particles are dispersed in the continuous phase at a particle-particle distance of at least twice the thickness of the layer of encapsulating material. This allows encapsulation of e.g. conductive particles without risk of percolation.

On the other hand it is clear to a person skilled in the art that minor differences in the substituent groups on the backbones of said first and second polymeric materials will not comprise the aim of obtaining a mechanically invisible encapsulation of particles as long as the backbones of said first and second polymeric materials are the same.

In an embodiment of the invention the first and second polymeric materials are elastomers.

In an embodiment of the invention the first and second polymeric materials are selected from the group consisting of silicone rubber, fluorosilicone rubber, poly(meth)acrylate rubber, chloroprene rubber, polybutadiene rubber, and polyurethane rubber.

In an embodiment of the invention the first and second polymeric materials are silicone rubbers selected from the group consisting of polysiloxanes, such as polyalkylsiloxanes, preferably polydimethylsiloxane (PDMS). Examples of PDMS rubbers include vinyl-functional PDMS crosslinked with hydride-functional crosslinking agents or hydroxyl-functional PDMS crosslinked in the presence of Sn. A non-limiting example of a commercially available PDMS is Elastosil RT625 from Wacker Chemie, Germany.

In an embodiment of the invention the discontinuous phase comprises at least 10% by volume of the composition, preferably at least 20% by volume, more preferably at least 30% by volume, such as at least 40% by volume of the composition.

In an embodiment of the invention the filler material comprises a solid comprising one or more selected from the group consisting of an electrically conductive material, a magnetic substance, and a tracer substance.

In an embodiment of the invention the filler material is a conjugated polymer, such as polyaniline and polypyridine, or electrically conductive yarns and fibres such as metal coated cotton, polyester or polyamide, such as carbon coated cotton, polyester or polyamide.

In an embodiment of the invention the filler material is a magnetic substance such as ferrocene, cobalt ferrite or magnetite nanoparticles.

In an embodiment of the invention the filler material is a biological tracer, such as copper, titanium, gold or silver, a luminescent tracer such as a fluorescent tag. A non-limiting example of a fluorescent tag comprises coumarin based fluorescent tags such as 4-methyl-7-(prop-2-en-1-yloxy)-2H-chromen-2-one and 3-(4-hydroxyphenyl)-7-(prop-2-en-1-yloxy)-4H-chromen-4-one.

In an embodiment of the invention the solid comprises one or more selected from the group consisting of graphite, including expanded graphite, carbon black, conjugated polymers such as polyaniline, polypyridine, and Ag powder, preferably expanded graphite. Expanded graphite is advantageously employed as filler material since it is naturally abundant, has high conductivity and is of low cost.

In an embodiment of the invention the filler material comprises a liquid selected from the group consisting of water, a saline solution, an ionic liquid, and an ionic network. Non-limiting examples of an ionic network are telechelic poly(ethylene glycol)s, such as carboxylic acid-telechelic poly(ethylene glycol)s, optionally protonated with amines.

In an embodiment of the invention the filler material comprises an ionic liquid. Non-limiting examples thereof include imidazolium salts and pyridinium salts.

In an embodiment of the invention the filler material comprises one or more gases. Non-limiting examples of a gas for use as filler according to the invention is CO₂, air, flame retardants such as organic halides or mixtures thereof.

In an embodiment of the invention the filler material is a combination of one or more solids, liquid and/or gases.

In an embodiment of the invention having the composition has a dielectric permittivity at 1 Hz of at least 3, preferably at least 3,5, such as at least 4,5.

### EXAMPLE 1

Preparation of silicone spheres containing conductive graphite as filler material

Elastosil RT625 from Wacker Chemie, which is a two-component (A+B) room temperature vulcanizing silicone rubber was used as the matrix for conductive graphite particles.

0.5 g expanded graphite particles supplied as TIMREX® BNB90 obtained by Timcal was mixed with 5 g of premix A of Elastosil RT625. The mixing was performed in a Speed Mixer™ in a DAC (Dual Asymmetric Centrifuge) 150 FVZ-K which operates in the 500-3500 rpm range. Subsequently the mixture was treated with ultrasound for 5 minutes. This resulted in what was denoted Elastosil A'.

Elastosil A'+B were then mixed in the prescribed ratio of 9:1 by weight after taking into account the changed density of mixture which means it was mixed in a ratio of 9:1.1.

The mixture was transferred dropwise to a 1% PVA+1% SDS aqueous surfactant solution at room temperature with a magnetic stirrer operating at 1000 rpm. The speed was maintained for two minutes and then turned down to 200 rpm whereafter the solution was heated to 50 degrees to facilitate curing. The mixture was left over night to form crosslinked particles of filler material comprising expanded graphite.

A new mixture of Elastosil (A: B = 9:1) was prepared and added dropwise to the aqueous solution above (at 1000 rpm for 2 minutes) and then turned down to 200 rpm whereafter the solution was heated to 50 degrees to facilitate curing. The mixture was left over night.

The obtained particles consisted mainly of coated (light grey) particles with a very small amount of clear particles indicating that the second procedure caused a transparent encapsulating coating of the dark grey particles from Elastosil A'.

1.8 g of the obtained encapsulated particles were transferred to 4 g of a mixture of 1:10 A: B Elastosil RT625 and mixed in a Speed mixer. The resulting mixture was coated on a release liner and the film was cured in the oven at 80°C for 2 hours.

### EXAMPLE 2

### Preparation of silicone spheres containing saline water as filler material (double emulsion O/W (oil/water))

A silicone bath was prepared from Elastosil RT625(Wacker Chemie) dissolved in silicone oil (os20 from Dow Corning). The mixing ratio of components A and B from Elastosil RT625 and oil was A:B:oil=1.2:9:5 and the total mass was 20 g. The mixture was stirred at 2000 rpm at room temperature and 10 g saline water (1% NaCl) was added dropwise. When the drops had been added the mixture was stirred for 30 seconds before it was transferred dropwise to a surfactant bath (250 mL) consisting of water with 1%SDS and 1%PVA. The mixture was stirred at 2000 rpm, and the speed was reduced to 200 rpm when the drops had been added. The mixture was then heated to 50°C and the particles were allowed to react for 5 hours before filtering.

The water core silicone shell (WS) spheres were filtered and washed with water.

2 g of WS were transferred to 4 g of a mixture of 1:10 A: B Elastosil RT625 and mixed in a Speed mixer. The resulting mixture was coated on a release liner and the film was cured in the oven at 80°C for 2 hours.

### LIST OF REFERENCES

Opris et al., "New Silicone Composites for Dielectric Elastomer Actuator Applications in Competition with Acrylic Foil", Advanced Functional Materials, 2011, XXI, 3531
Kussmaul et al., "Matrix stiffness dependent electro-mechanical response of dipole grafted silicones", Smart Materials and Structures, 2012, 21, 064005
US 4,777,205
US 2012/0128960 A1

## Claims

1. A composition comprising a continuous phase and a discontinuous phase incorporated therein, wherein the continuous phase comprises a first polymeric material and wherein the discontinuous phase comprises particles, said particles comprising a filler material and an encapsulating coating of a second polymeric material, wherein the backbones of the first and second polymeric materials are the same.

2. The composition according to claim 1, wherein at least 80 % by mole of the substituent groups on the backbones of said first and second polymeric materials are identical.

3. The composition according to claim 1 or 2, wherein at least 85 % by mole of the substituent groups on the backbones of said first and second polymeric materials are identical, preferably at least 90 % by mole, more preferably at least 95 % by mole of the substituent groups on the backbones of said first and second polymeric materials.

4. The composition according to any one of the preceding claims, wherein the first and second polymeric materials are elastomers.

5. The composition according to any one of the preceding claims, wherein the first and second polymeric materials are selected from the group consisting of silicone rubber, fluorosilicone rubber, poly(meth)acrylate rubber, chloroprene rubber, polybutadiene rubber, and polyurethane rubber.

6. The composition according to any one of the preceding claims, wherein the first and second polymeric materials are silicone rubbers selected from the group consisting of polysiloxanes, such as polyalkylsiloxanes, preferably polydimethylsiloxane (PDMS).

7. The composition according to any one of the preceding claims, wherein the discontinuous phase comprises at least 10% by volume of the composition, preferably at least 20% by volume, more preferably at least 30% by volume, such as at least 40% by volume of the composition.

8. The composition according to any one of the preceding claims, wherein the filler material comprises a solid comprising one or more selected from the group consisting of an electrically conductive material, a magnetic substance, and a tracer substance.

9. The composition according to claim 8, wherein the solid comprises one or more selected from the group consisting of graphite, including expanded graphite, carbon black, conjugated polymers such as polyaniline, polypyridine, and Ag powder, preferably expanded graphite.

10. The composition according to any one of claims 1-7, wherein the filler material comprises a liquid selected from the group consisting of water, a saline solution, an ionic liquid, and an ionic network.

11. The composition according to any one of claims 1-7, wherein the filler material comprises one or more gases.

12. The composition according to any one of the preceding claims, having a dielectric permittivity at 1 Hz of at least 3, preferably at least 3,5, such as at least 4,5.

13. A method for the preparation of a composition according to any one of the preceding claims, comprising the steps:
i) preparing particles comprising a filler material;
ii) Encapsulating said particles, optionally with heating, with a second polymeric material to obtain encapsulated particles;
iii) Mixing the encapsulated particles obtained in ii), optionally with heating, with a first polymeric material to obtain a composition comprising a continuous phase and a discontinuous phase.

14. A use of the composition according to any one of claims 1-12 as electroactive polymer.

15. A use of the composition according to any one of claims 1-12 for the preparation of closed cell foams.

## Patentansprüche

1. Zusammensetzung, die eine kontinuierliche Phase und eine darin integrierte diskontinuierliche Phase umfasst, wobei die kontinuierliche Phase ein erstes polymeres Material umfasst und wobei die diskontinuierliche Phase Teilchen umfasst, wobei die Teilchen ein Füllmaterial und eine Einkapselungsbeschichtung aus einem zweiten polymeren Material umfassen, wobei die Grundgerüste der ersten und zweiten polymeren Materialien dieselben sind.

2. Zusammensetzung nach Anspruch 1, wobei mindestens 80 Mol% der Substituentengruppen an den Grundgerüsten der ersten und zweiten polymeren Materialien identisch sind.

3. Zusammensetzung nach Anspruch 1 oder 2, wobei mindestens 85 Mol% der Substituentengruppen an den Grundgerüsten der ersten und zweiten polymeren Materialien identisch sind, vorzugsweise mindestens 90 Mol%, besonders bevorzugt mindestens 95 Mol% der Substituentengruppen an den Grundgerüsten der ersten und zweiten polymeren Materialien.

4. Zusammensetzung nach einem der vorherigen Ansprüche, wobei die ersten und zweiten polymeren Materialien Elastomere sind.

5. Zusammensetzung nach einem der vorherigen Ansprüche, wobei die ersten und zweiten polymeren Materialien ausgewählt sind aus der Gruppe bestehend aus SilikonKautschuk, Fluorsilikon-Kautschuk, Polymethacrylat-Kautschuk, Chloropren-Kautschuk, Polybutadien-Kautschuk und Polyurethan-Kautschuk.

6. Zusammensetzung nach einem der vorherigen Ansprüche, wobei die ersten und zweiten polymeren Materialien Silikon-Kautschuke sind, die ausgewählt sind aus der Gruppe bestehend aus Polysiloxanen, wie etwa Polyalkylsiloxanen, bevorzugt Polydimethylsiloxan (PDMS).

7. Zusammensetzung nach einem der vorherigen Ansprüche, wobei die diskontinuierliche Phase mindestens 10 Vol.% der Zusammensetzung umfasst, vorzugsweise mindestens 20 Vol.%, besonders bevorzugt mindestens 30 Vol.%, wie etwa mindestens 40 Vol.% der Zusammensetzung.

8. Zusammensetzung nach einem der vorherigen Ansprüche, wobei das Füllmaterial einen Feststoff umfasst, der ein oder mehrere umfasst, die ausgewählt sind aus der Gruppe bestehend aus einem elektrisch leitfähigen Material, einer magnetischen Substanz und einer Tracersubstanz.

9. Zusammensetzung nach Anspruch 8, wobei der Feststoff ein oder mehrere umfasst, die ausgewählt sind aus der Gruppe bestehend aus Graphit, einschließlich expandiertem Graphit, Ruß, konjugierten Polymeren, wie etwa Polyanilin, Polypyridin, und Ag-Pulver, vorzugsweise expandiertem Graphit.

10. Zusammensetzung nach einem der Ansprüche 1 bis 7, wobei das Füllmaterial eine Flüssigkeit umfasst, die ausgewählt ist aus der Gruppe bestehend aus Wasser, einer Salzlösung, einer ionischen Flüssigkeit und einem ionischen Netzwerk.

11. Zusammensetzung nach einem der Ansprüche 1 bis 7, wobei das Füllmaterial ein oder mehrere Gase umfasst.

12. Zusammensetzung nach einem der vorherigen Ansprüche, die eine dielektrische Permittivität bei 1 Hz von mindestens 3, vorzugsweise mindestens 3,5, wie etwa mindestens 4,5 aufweist.

13. Verfahren zur Herstellung einer Zusammensetzung nach einem der vorherigen Ansprüche, das die folgenden Schritte umfasst:
i) Herstellung von Teilchen, die ein Füllmaterial umfassen;
ii) Einkapseln der Teilchen, wahlweise unter Erwärmen, mit einem zweiten polymeren Material, um eingekapselte Teilchen zu erhalten;
iii) Mischen der in ii) erhaltenen eingekapselten Teilchen, wahlweise unter Erwärmen, mit einem ersten polymeren Material, um eine Zusammensetzung zu erhalten, die eine kontinuierliche Phase und eine diskontinuierliche Phase umfasst.

14. Verwendung der Zusammensetzung nach einem der Ansprüche 1 bis 12 als elektroaktives Polymer.

15. Verwendung der Zusammensetzung nach einem der Ansprüche 1 bis 12 zur Herstellung von geschlossenzelligen Schaumstoffen.

## Revendications

1. Composition comprenant une phase continue et une phase discontinue incorporée à l'intérieur, dans laquelle la phase continue comprend un premier matériau polymère et dans laquelle la phase discontinue comprend des particules, lesdites particules comprenant un matériau de remplissage et un revêtement d'encapsulation d'un second matériau polymère, dans laquelle les squelettes des premier et second matériaux polymères sont identiques.

2. Composition selon la revendication 1, dans laquelle au moins 80 % en moles des groupes substituants sur les squelettes desdits premier et second matériaux polymères sont identiques.

3. Composition selon la revendication 1 ou 2, dans laquelle au moins 85 % en moles des groupes substituants sur les squelettes desdits premier et second matériaux polymères sont identiques, de préférence au moins 90 % en moles, plus préférablement au moins 95 % en moles des groupes substituants sur les squelettes desdits premier et second matériaux polymères.

4. Composition selon l'une quelconque des revendications précédentes, dans laquelle les premier et second matériaux polymères sont des élastomères.

5. Composition selon l'une quelconque des revendications précédentes, dans laquelle les premier et second matériaux polymères sont sélectionnés dans le groupe constitué par un caoutchouc silicone, un caoutchouc fluorosilicone, un caoutchouc poly(méth)acrylate, un caoutchouc chloroprène, un caoutchouc polybutadiène et un caoutchouc polyuréthane.

6. Composition selon l'une quelconque des revendications précédentes, dans laquelle les premier et second matériaux polymères sont des caoutchoucs silicones sélectionnés dans le groupe constitué par les polysiloxanes, tels que les polyalkylsiloxanes, de préférence le polydiméthylsiloxane (PDMS).

7. Composition selon l'une quelconque des revendications précédentes, dans laquelle la phase discontinue représente au moins 10 % en volume de la composition, de préférence au moins 20 % en volume, plus préférablement au moins 30 % en volume, par exemple au moins 40 % en volume de la composition.

8. Composition selon l'une quelconque des revendications précédentes, dans laquelle le matériau de remplissage comprend un solide comprenant un ou plusieurs solides sélectionnés dans le groupe constitué par un matériau électriquement conducteur, une substance magnétique et une substance de traçage.

9. Composition selon la revendication 8, dans laquelle le solide comprend un ou plusieurs solides sélectionnés dans le groupe constitué par le graphite, y compris le graphite expansé, le noir de carbone, les polymères conjugués tels que la polyaniline, la polypyridine et la poudre d'Ag, de préférence le graphite expansé.

10. Composition selon l'une quelconque des revendications 1 à 7, dans laquelle le matériau de remplissage comprend un liquide sélectionné dans le groupe constitué par l'eau, une solution saline, un liquide ionique et un réseau ionique.

11. Composition selon l'une quelconque des revendications 1 à 7, dans laquelle le matériau de remplissage comprend un ou plusieurs gaz.

12. Composition selon l'une quelconque des revendications précédentes, ayant une permittivité diélectrique à 1 Hz d'au moins 3, de préférence d'au moins 3,5, par exemple d'au moins 4,5.

13. Procédé pour la préparation d'une composition selon l'une quelconque des revendications précédentes, comprenant les étapes consistant à :
i) préparer des particules comprenant un matériau de remplissage ;
ii) encapsuler lesdites particules, facultativement par chauffage, avec un second matériau polymère pour obtenir des particules encapsulées ;
iii) mélanger les particules encapsulées obtenues en ii), facultativement en chauffant, avec un premier matériau polymère pour obtenir une composition comprenant une phase continue et une phase discontinue.

14. Utilisation de la composition selon l'une quelconque des revendications 1 à 12 en tant que polymère électroactif.

15. Utilisation de la composition selon l'une quelconque des revendications 1 à 12 pour la préparation de mousses à cellules fermées.
